# EUROPEAN PATENT APPLICATION

(11) **EP 2 066 159 A1**
(43) Date of publication of application: **03.06.2009**
(21) Application number: 07121687.3
(22) Date of filing: 27.11.2007
(51) Int. Cl.: H05K 3/10, H05K 3/40

(54) **Method of providing conductive structures in a multi-foil system and multi-foil system comprising same**

(71) Applicant: Nederlandse Organisatie voor Toegepast- Natuurwetenschappelijk Onderzoek TNO, 2628 VK Delft (NL)
(72) Inventor: Dietzel, Andreas Heinrich, 47906 Kempen (DE); Michels, Jasper Joost, 5211 LD 's-Hertogenbosch (NL); van den Brand, Jeroen, 5053 AT Goirle (NL); Meinders, Erwin Rinaldo, 5508 WB Veldhoven (NL)
(74) Representative: Hatzmann, Martin

(57) **Abstract**

According to one aspect, the invention provides a method of providing conductive structures in a multi-foil system comprising at least two foils (1), at least one foil comprising an electrical circuit with a terminal (2), comprising, in any successive order the steps of providing an adhesive (3) on at least one of the foils for bonding the foils, the adhesive at least provided on and around the terminal; and converting the conductivity properties of said adhesive within a conversion zone, so as to form the conductive structure (4); and bonding the at least two foils.

## Description

### Field of invention

The invention relates to a system and device for manufacturing a multi-foil system, and more particularly the mechanical assembly of foils that have an electric function.

### Description of prior art

The present invention relates to the field of mechanically assembling multi-foil systems, i.e. flexible laminated electronic systems. In a particular type of these multi-foil systems, the so-called 'systems-in-foil', each foil may have a certain electric function, like a display foil, a battery foil or a solar panel foil. Systems-in-foil have numerous applications, e.g. in the fields of lighting and reusable and disposable sensor devices.

The individual foils may be made in large sizes and quantities at low costs, e.g. using production processes such as presently used in the paper printing industry. The individual foils may be manufactured on different locations and the system may be assembled on a central location.

A conventional method of bonding and electrically connecting foils is the micro-via technology. In this technology firstly, an adhesive is provided between the foils to bond them. Then, the foils are electrically connected by drilling vias and filling these vias with a conducting material, so as to create electrical interconnects. A disadvantage of this technology is that it comprises at least a via drilling step and a via filling step, in which a material is deposited. This technology is therefore slow and seems less suitable for fast foil manufacturing processes.

It is noted that a publication in the field of fabricating high density thin film circuits (US5489551) describes a method of creating electrical interconnects between a high-density connector and a solid substrate. The challenges in manufacturing a flexible multi-foil system significantly differ from the manufacturing of a solid thin film circuit.

In one aspect the invention aims to provide a method of bonding and electrically connecting a multi-foil system that can be used in a foil manufacturing process.

### Disclosure of the invention

According to one aspect, the invention provides a method of providing conductive structures in a multi-foil system comprising at least two foils, at least one foil comprising an electrical circuit with a terminal, comprising, in any successive order the steps of
- providing an adhesive on at least one of the foils for bonding the foils, the adhesive at least provided on and around the terminal; and
- converting the conductivity properties of said adhesive within a conversion zone, so as to form the conductive structure; and
- bonding the at least two foils.

According to another aspect, the invention provides a multi-foil system, comprising
- at least two foils, at least one comprising an electrical circuit with a terminal,
- an adhesive for bonding said foils, the adhesive at least provided on and around the terminal, wherein the adhesive comprises a conductive conversion component, sensitive to heat, em-radiation, electron beam radiation, pressure or a combination thereof to be converted within a conversion zone, so as to form conductive structures in the adhesive.

According to yet another aspect, the invention provides a manufacturing system for multi-foil systems, comprising
- a foil feed, for providing a foil,
- a bonding unit, arranged to provide an adhesive at least on and around a terminal comprised in said foil, and
- a conversion unit arranged for converting a conductive conversion component comprised in the adhesive, sensitive to heat, em-radiation, electron beam radiation, pressure or a combination thereof, so as to form conductive structures in said adhesive.

The present invention will become more readily apparent from the following detailed description of the preferred embodiments of the present invention taken in conjunction with the accompanying drawings.

### Brief description of the drawings

Figure **1****:** Side view of an embodiment of the invention in the form of a two-foil stack.
Figure **2****:** Top view of possible sizes and shapes of the terminals.
Figure **3****:** Side view of forming an electrical interconnect (a) in a non-conductive adhesive, wherein the conductive conversion component is converted from non-conductive to conductive, and (b) in a conductive adhesive, wherein the conductive conversion component is converted from conductive to non-conductive.
Figure **4****:** Side view of an embodiment comprising a laser.
Figure **5****:** Top view of at least partially transparent terminals comprising various aperture structures.
Figure **6****:** Top view of misaligned foils comprising terminals, showing partial and no overlap between the terminals.
Figure **7****:** Top and side view of interconnects in case of partial and no overlap between the terminals.
Figure **8****:** Side view of an embodiment comprising a stack of more than two foils.
Figure **9****:** Schematic representation of a manufacturing system for multi-foil systems.

### Description of the embodiments

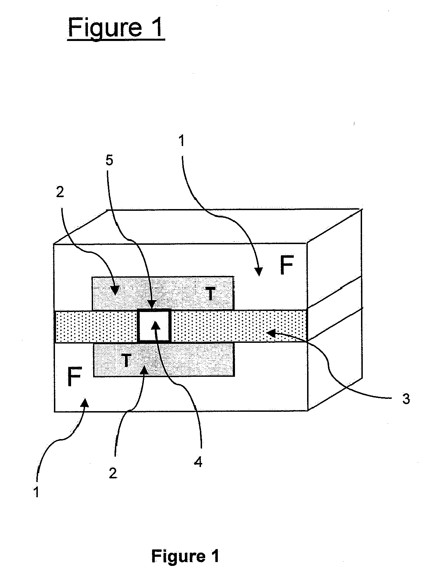

One embodiment of the multi foil system according to the present invention is shown in FIG. 1 and comprises a stack of two foils. Each foil (1) comprises an electrical circuit with a terminal (2). An adhesive (3) is provided to bond the foils. The conductivity properties of the adhesive are converted to form a conductive structure in the form of an electrical interconnect (4) between the two terminals (2).

The adhesive comprises a conductive conversion component that can be converted, so as to form conductive structures. In one embodiment, the conversion component is sensitive to em-radiation. A typical form of em-radiation to be used is light, but other sources of em-radiation are also contemplated. In another embodiment, the conversion component is sensitive to electron beam radiation. In yet another embodiment, the conversion component is sensitive to pressure. One embodiment comprises a conversion component sensitive to heat. The conversion component can also be sensitive to a combination of em-radiation, electron beam radiation, pressure or heat.

To form conductive structures, the conversion of the component has to take place locally, leaving the rest of the component unconverted. The heat, em-radiation, electron beam radiation, pressure or a combination thereof will therefore be applied within a conversion zone (5), causing the conductive conversion component to convert only within this zone.

The foils (1) are functional foils, each having an electric function. Exemplary functions of foils are display foils, battery foils, solar panel foils and sensor foils.

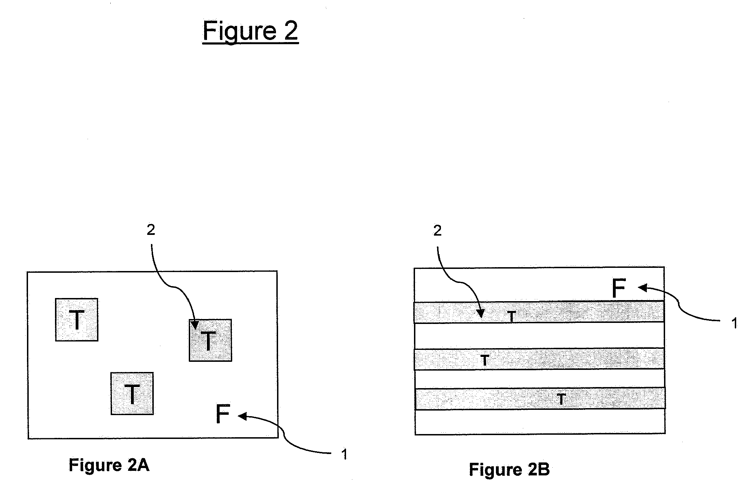

The terminals (2) can be of various sizes and shapes. Some examples are shown in FIG. 2A and 2B, where top views of electrical pads and electrical lines are shown respectively.

Depending on the type of adhesive, the conversion of the conductivity properties of the adhesive can be realized by various mechanisms. Some examples of these mechanisms are given below.

In one type of adhesive, a so-called non-conductive Anisotropic Conductive Adhesive (ACA), the adhesive, comprising conductive particles, is compressed until the percolation threshold of the particles is surpassed, resulting in a conductive structure.

In another type of adhesive pyrolysis takes place. Pyrolysis causes a decomposition of the adhesive under the influence of heat into, among others, an electrically conducting material, e.g. an electrically conducting carbon material. This type of adhesives can be selected from the group of non-conductive organic thermoplastic adhesives and non-conductive organic adhesives.

To yet another type of adhesive, comprising conductive particles and a photocatalyst, light or other em-radiation is applied. The conductive particles are embedded in an insulating shell. Photo-absorption causes the insulating shell to rupture, causing a conversion of the adhesive from non-conductive to conductive. This mechanism can also take place under the influence of heat, in which case the heat causes the non-conductive shells to rupture.

Also a combination of the types of adhesive mentioned above is also possible.

One of the adhesives contemplated comprises Emerson XE3103WLV isotropic conducting adhesive, an epoxy adhesive with 76% by weight silver content.

In one embodiment, the whole surface of the foil is covered by a convertible adhesive (3). However, to save costs, the expensive convertible adhesive can only be provided on and around the terminals (2), whereas in other areas a cheaper, non-convertible adhesive can be provided. In this way, special I/O fields may create substructures in which an array of individual contacts with a high resolution (fine pitch) is defined.

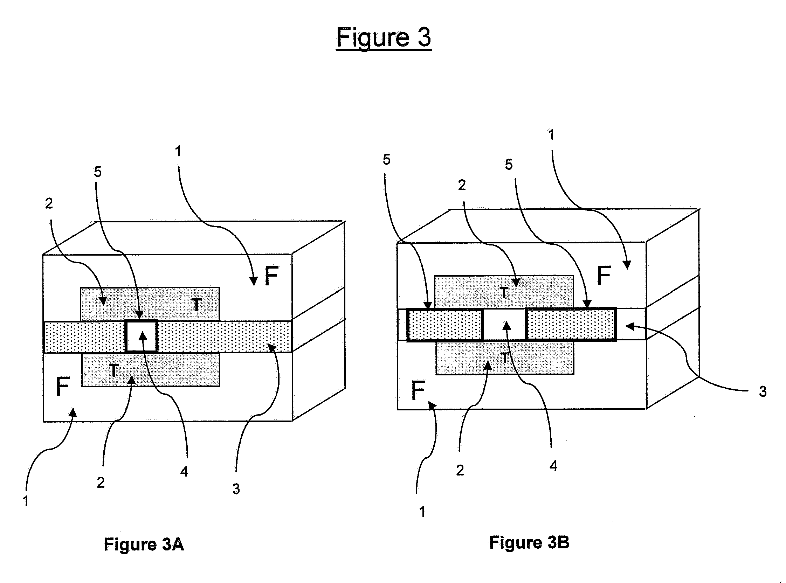

In one embodiment, the adhesive is non-conductive and the conductivity properties of the adhesive are converted from non-conductive to conductive. In FIG. 3A, an embodiment is shown wherein the conductive conversion component is converted within a channel shaped conversion zone (5) between conductive terminals (2), providing an electrical interconnect (4) between the corresponding terminals (2).
In another embodiment, the conductive adhesive is converted from conductive to non-conductive. As illustrated in FIG. 3B, in this case, the electrical interconnect (4) is formed by a conversion from conductive to non-conductive within two conversion zones (5) encapsulating the conductive adhesive between two non-conductive parts of the adhesive, providing an electrical interconnect (4) between the corresponding terminals (2).

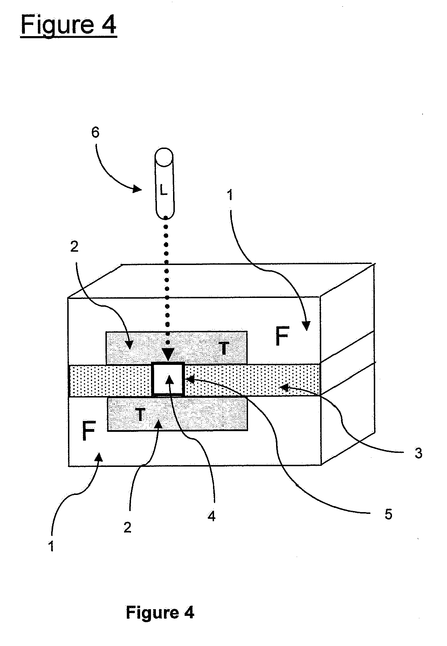

In FIG. **4****,** an embodiment is shown in which heat and light are provided within the conversion zone (5) by a laser (6). According to the desired conductive structure, the laser scanning and intensity has to be steered over the contact area. In one embodiment, the laser (6) is guided by the conversion unit present in the manufacturing system for multi-foil systems on basis of adjustment signals. The adjustment signals indicate the positioning error of the foils and/or the terminals. In one embodiment, the conversion unit receives the adjustment signal by reading a pattern of marks provided on the foil. In another embodiment, the adjustment signals are sent to the conversion unit by the aligning mechanism on basis of the actual alignment inaccuracies. In yet another embodiment, the laser is guided by a soft mask. A soft mask is a stream file that provides the parameters for the laser scanning. It can be combined with image recognition on already present structures. In another embodiment the light is provided through lithographic techniques.

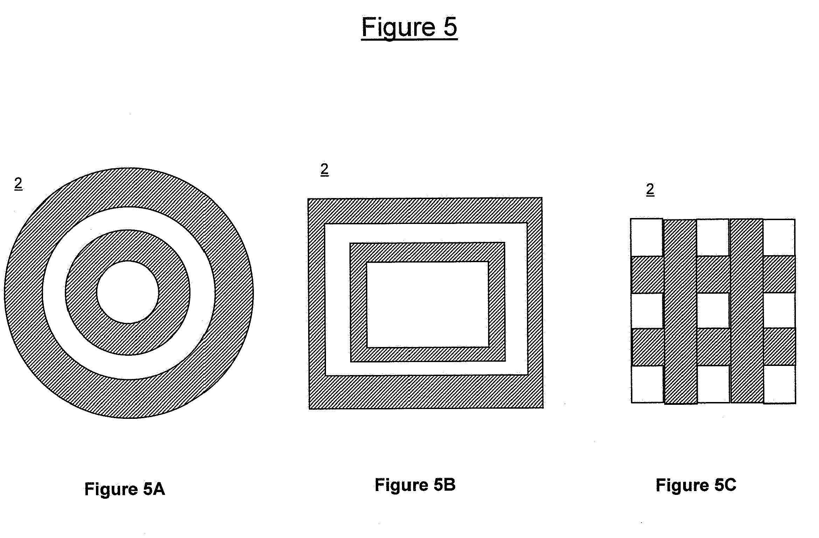

To create electrical interconnects, the em-radiation or the electron beam radiation must pass the terminals (2) to reach the conversion zone (5). Therefore, in one embodiment, the terminals (2) comprise apertures, which can be provided in various structures. Examples of these structures can be found in FIG. 5. FIG. 5A shows the apertures in a concentric pattern, in FIG. 5B a rectangular structure is shown and in FIG. 5C the apertures form a grid-like structure.
In an alternative embodiment, the terminals (2) are, at least partially, optically transparent.

In order not to hinder the em-radiation or the electron beam radiation penetrating the foils, the foils have to be transparent too, at least partially. They can comprise e.g. PolyEthylene Naphthalate (PEN), Indium Tin Oxide (ITO) or a combination thereof. ITO can be applied to a biaxially oriented PET film by sputter deposition. Other materials are however possible. In one embodiment, materials with a difference in refractive indexes are used to focus the intensity of the em-radiation.

The present invention can be used in a manufacturing process, e.g. a reel-to-reel, roll-to-roll or a sheet-to-sheet manufacturing process. In such a process, inaccuracies in the positioning of the various elements will be inevitable, resulting in a positioning error.

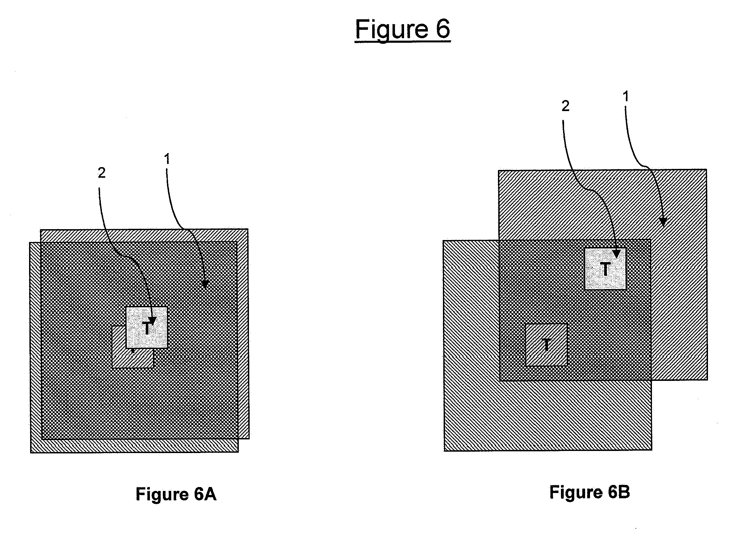

Many error sources may contribute to the positioning error. In the following some of these sources will be discussed.
One error source contributing to the positioning error is inaccuracy in the alignment of the foils (1). This inaccuracy can occur both longitudinal and transversal to the direction of movement of the foils (1). An exploded view of the misalignment, resulting in partial overlap of the terminals is schematically shown in FIG. 6A. In FIG. 6B, the positioning error is such that no overlap occurs between the terminals (2).
Another error source contributing to the positioning error is inaccuracy in guiding the laser beam with respect to the foil.
Yet another possible error source contributing to the positioning error occurs during the manufacturing of the individual foils. The pattern of the terminals in the foil may differ from the designed pattern.
Many other error sources contribute to the positioning error. The significance of the contribution of the various sources may depend on the specific embodiment of the invention.

If the present invention is part of a manufacturing process, the conversion of the adhesive will preferably be done with a contactless mechanism. Heat, light or other em-radiation may be provided by a laser (6) or an electron beam radiation source may be used. However, in certain situations, e.g. when heat is a critical factor, a stylus may be used to apply pressure to the conversion zone (5).

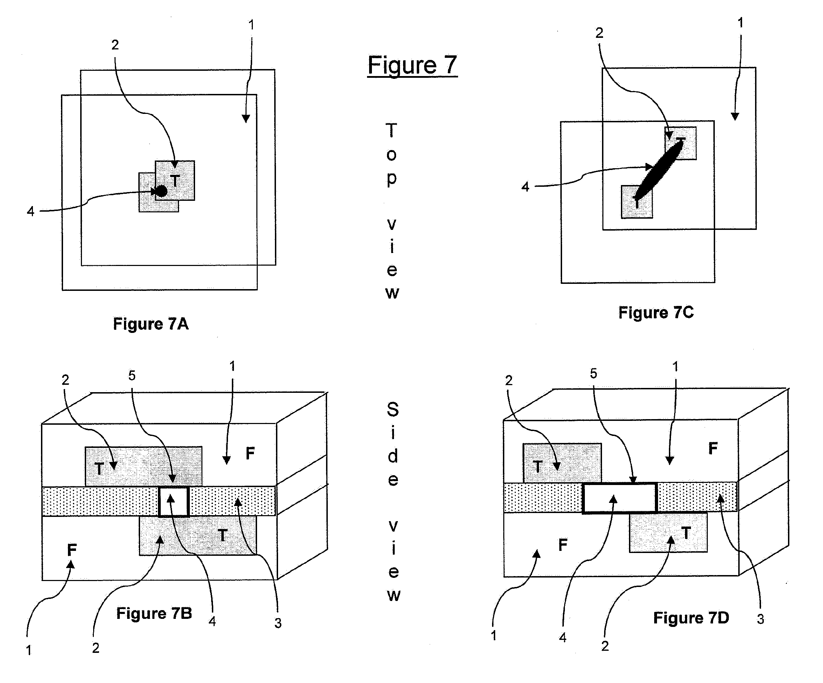

One of the advantages of the present invention is that positioning errors can be overcome by adjusting the conversion zone (5) both in size and shape to form interconnects between corresponding terminals (2). In FIG. 7, exemplary conversion zones are shown. FIGS. 7A and FIG. 7B show a top and a side view of a situation in which the terminals partially overlap, FIGS. 7C and 7D show a top and a side view of a situation wherein the terminals do not overlap at all. In the top views, the conversion zones are indicated by the black circular and elliptic forms (4). In FIG. 7 is also shown that the shape of the conversion zone (5) elongates with increasing positioning error.

To provide heat, em-radiation, electron beam radiation, pressure or a combination thereof in a conversion zone, the source(s) has to move relative to the foil.
One possibility to create relative movement between the foil and the source is by moving the foil only, while the source is fixed. It is also possible that only the source is moving. The movement of the source can be in longitudinal and transversal direction relative to the foils, or in one of these directions. A combined movement of the foil and the source is also possible. It is also contemplated that another degree of freedom is added to the movement by varying the angle of the source relative to the foils, resulting in an angled (non-perpendicular) incidence of the beam on the foils.

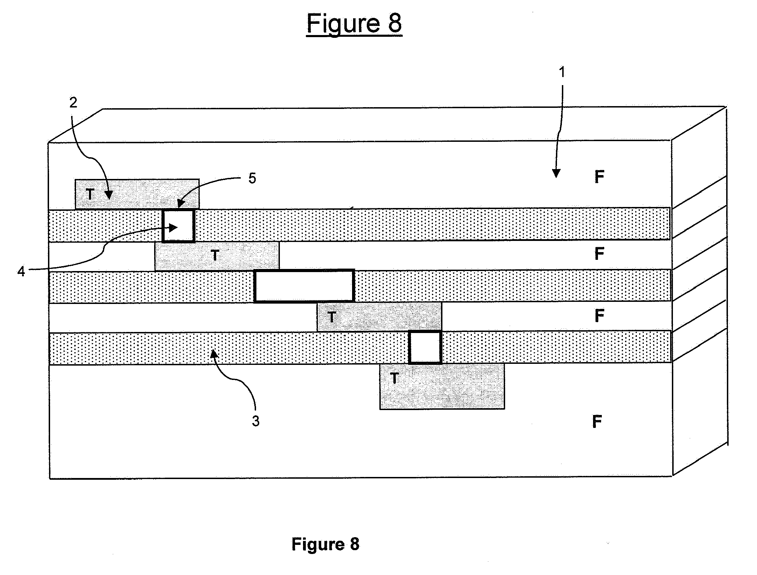

FIG. 8 shows an embodiment comprising a stack of more than two foils. This can be achieved by successively adding one additional foil or by simultaneously laminating several foils. In case of a stack comprising more than two foils, a selective addressing of certain foils (depth selectivity) by the laser (6) or the electron beam radiation source is necessary. Conversion properties of the adhesive can be tuned to have maximum energy deposition only in the adhesive and not in the foils above and below, as not to interfere with contacts already fabricated in a previous run. The stacked foil system remains flexible.

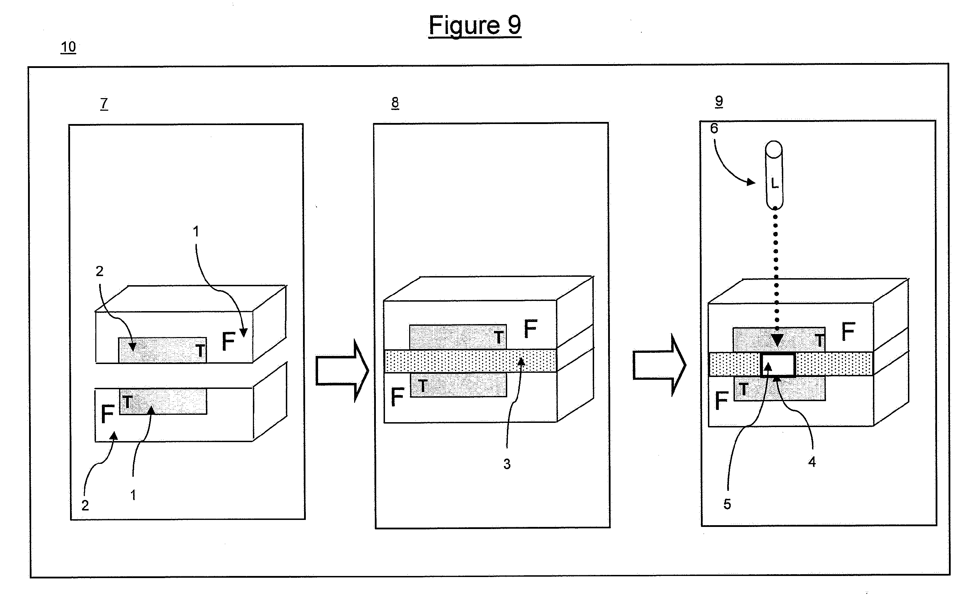

One embodiment of a manufacturing system for multi-foil systems is schematically shown in FIG. 9. In this example the manufacturing system (10) comprises three units. The first unit is a foil feed (7), arranged for providing foils (1) comprising a terminal (2). The second unit is a bonding unit (8), providing an adhesive (3) on the foils (1) provided by the foil feed (7). The adhesive (3) is at least provided on and around the terminal (2). The third unit is a conversion unit (9), arranged for converting a conductive conversion component comprised in the adhesive (3) provided by the bonding unit (8), so as to form conductive structures in the adhesive (3). Further, in this embodiment, the conversion unit (9) comprises a laser (6) to provide light within the conversion zone (4), so as to create an electrical interconnect (5) in the adhesive.

In the embodiment of FIG. 9, a certain order is suggested in which the units operate: first the foil feed (7), then the bonding unit (8) en finally the conversion unit (9). It should however be noted that this particular order is not essential. The conversion of the adhesive (3) may also take place before the foils are bonded. In this case, the adhesive (3) is provided on at least one of the foils (1) and the conductive structure is provided by converting the adhesive (3). Subsequently the foils (1) are bonded. An advantage of this order is that the em-radiation, electron beam radiation, pressure, heat or a combination thereof can reach the adhesive (3), not hindered by a foil (1).
In the description of the embodiment, the adhesive (3) is provided on at least one of the foils (1) and the foils (1) are bonded. Subsequently the conductive structure is provided by converting the adhesive (3). An advantage of this order of steps is that the conductive structure can be adapted to positioning errors in the bonding of the foils (1).

The detailed drawings, specific examples and particular formulations given serve the purpose of illustration only. In the embodiments described, the conversion zone is chosen in such a way that the conductive structure forms an electrical interconnect between terminals comprised in various foils. It is however also possible to create a conductive structure, e.g. in the form of a conductive wire grid, for connecting terminals within the same foil. Furthermore, other substitutions, modifications, changes, and omissions may be made in the design, operating conditions, and arrangement of the exemplary embodiments without departing from the scope of the invention as expressed in the appended claims.

## Claims

1. Method of providing conductive structures in a multi-foil system comprising at least two foils, at least one foil comprising an electrical circuit with a terminal, comprising, in any successive order the steps of
a. providing an adhesive on at least one of the foils for bonding the foils, the adhesive at least provided on and around the terminal; and
b. converting the conductivity properties of said adhesive within a conversion zone, so as to form the conductive structure; and
c. bonding the at least two foils.

2. The method of claim 1, wherein the conductive structure forms an electrical interconnect between corresponding terminals in the at least two foils.

3. The method of claim 1, wherein the conversion of the conductivity properties comprises providing heat, em-radiation, electron beam radiation, pressure or a combination thereof to the conversion zone.

4. The method of claim 1, further providing said foils on at least two reels, further comprising the step of aligning said foils with regard to the terminals comprised in said foils, so as to be used in a reel-to-reel manufacturing process.

5. The method of claim 1, wherein the conversion zone is adjusted by an adjustment signal, indicative of a positioning error of the terminals and/or the foils.

6. The method of claim 5, wherein the shape of the conversion zone elongates with increasing positioning error.

7. The method of claim 1, wherein the conductivity properties of said adhesive are converted from non-conductive to conductive.

8. The method of claim 1, wherein the conductivity properties of said adhesive are converted from conductive to non-conductive.

9. A multi-foil system, comprising
a. at least two foils, at least one comprising an electrical circuit with a terminal,
b. an adhesive for bonding said foils, the adhesive at least provided on and around the terminal, wherein the adhesive comprises a conductive conversion component, sensitive to heat, em-radiation, electron beam radiation, pressure or a combination thereof to be converted within a conversion zone, so as to form conductive structures in the adhesive.

10. The system of claim 9, wherein the conductive structure comprises an electrical interconnect between corresponding terminals in the at least two foils.

11. The system of claim 9, wherein said terminals comprise apertures or are at least partially optically transparent, to allow the light provided by the laser to pass through to the conversion zone.

12. A manufacturing system for multi-foil systems, comprising
a. a foil feed, for providing a foil,
b. a bonding unit, arranged to provide an adhesive at least on and around a terminal comprised in said foil, and
c. a conversion unit arranged for converting a conductive conversion component comprised in the adhesive, sensitive to heat, em-radiation, electron beam radiation, pressure or a combination thereof, so as to form conductive structures in said adhesive.

13. The system of claim 12, the conversion unit further comprising a laser to provide the heat and/or light within the conversion zone.

14. The system of claim 13, wherein the conversion unit comprises a control unit to steer the laser scanning and intensity.

15. The system of claim 12, wherein the conversion unit is arranged to adjust the conversion zone on basis of an adjustment signal, indicative of a positioning error of the terminals and/or the foils.
